## Europäisches Patentamt
## European Patent Office
## Office européen des brevets

(19)

(11) Veröffentlichungsnummer: **0 039 430**
**B1**

(12) **EUROPÄISCHE PATENTSCHRIFT**

(45) Veröffentlichungstag der Patentschrift:
**19.09.84**

(21) Anmeldenummer: **81102842.2**

(22) Anmeldetag: **14.04.81**

(51) Int. Cl.³: **H 03 F 3/217, H 03 F 3/387**

(54) **Audio-Leistungsverstärker mit D-Gegentakt-Endstufe.**

(30) Priorität: **07.05.80 DE 3017414**

(43) Veröffentlichungstag der Anmeldung:
**11.11.81 Patentblatt 81/45**

(45) Bekanntmachung des Hinweises auf die Patenterteilung:
**19.09.84 Patentblatt 84/38**

(84) Benannte Vertragsstaaten:
**DE FR GB IT NL**

(56) Entgegenhaltungen:
**US - A - 3 480 881**
**US - A - 3 541 461**
**US - A - 3 900 823**
**US - A - 4 121 205**
**US - A - 4 153 882**

**ELECTRONIQUE ET APPLICATION INDUSTRIELLE,**
Band 271, 15. Juni 1979, Seiten 54-55 Paris, FR.
"Amplificateur audio 100 W classe D à VMOS"

(73) Patentinhaber: **Deutsche ITT Industries GmbH,
Hans-Bunte-Strasse 19 Postfach 840, D-7800 Freiburg
(DE)**

(84) Benannte Vertragsstaaten: **DE FR GB IT NL**

(73) Patentinhaber: **ITT INDUSTRIES INC., 320 Park Avenue,
New York, NY 10022 (US)**

(84) Benannte Vertragsstaaten: **FR GB IT NL**

(72) Erfinder. **Miskin, Leslie, Industriestrasse 2A,
D-7803 Gundelfingen (DE)**

(74) Vertreter: **Stutzer, Gerhard, Dr., Deutsche ITT Industries
GmbH Patent- und Lizenzabteilung
Hans-Bunte-Strasse 19 Postfach 840, D-7800 Freiburg
(DE)**

## Beschreibung

Handelsübliche D-Gegentakt-Endstufen werden gewöhnlich mit einer Chopperfrequenz in der Größenordnung von 500 kHz betrieben. Soll das pulsbreitenmodulierte Ansteuersignal nicht nach analogen, sondern digitalen Verfahren erzeugt werden, so benötigt man zur Erzeugung des pulsbreitenmodulierten Signals eine sehr hohe Taktfrequenz. Zur Erläuterung dieses Problems sei angenommen, daß für ein erforderliches Auflösungsvermögen zehn Informationsbits erforderlich sind, was bedeutet, daß etwa $10^3$ ($2^{10}$ = 1024) Taktimpulse pro Chopperperiode maximal auftreten können, d. h. der Taktgenerator muß eine Frequenz in der Größenordnung von 500 MHz haben. Die Chopperfrequenz von 500 kHz wird in dieser Größenordnung im allgemeinen deswegen gewählt, weil erst bei derart hohen Frequenzen Kreuzmodulationssignale des zu verstärkenden Ausgangssignals mit der Chopperfrequenz nicht mehr im zu verstärkenden Frequenzband liegen.

Taktfrequenzen in der Größenordnung von 500 MHz liegen andererseits jedoch so hoch, daß für die digitale Erzeugung des pulsbreitenmodulierten Signals für D-Gegentakt-Endverstärker ein anderer Weg gesucht werden muß. Der Erfindung liegt somit die Aufgabe zugrunde, einen Audio-Leistungsverstärker mit D-Gegentakt-Endstufe anzugeben, bei dem das pulsbreitenmodulierte Signal digital, also z. B. mittels Zählern, erzeugt ist, dessen Taktfrequenz jedoch wesentlich niedriger liegen kann als in der Größenordnung von 500 MHz.

Diese Aufgabe wird bei einem aus der Zeitschrift »Electronique et Application Industrielle«, 15. Juni 1979, Seiten 54 und 55 bekannten Audio-Leistungsverstärker nach dem Oberbegriff des Patentanspruchs durch die kennzeichnenden Merkmale gelöst. Das der Erfindung zugrunde liegende Prinzip besteht somit darin, eine »Mischung« zwischen Pulsbreitenmodulation und Pulsamplitudenmodulation anzuwenden und mit dem daraus resultierenden Kombinationssignal die D-Gegentakt-Endstufe anzusteuern. Hierzu wird das digitale Ausgangssignal des in der Eingangsstufe liegenden Analog-Digital-Wandlers derart bezüglich der Weiterverarbeitung aufgeteilt, daß lediglich dessen höherwertige Stellen den Pulsbreitenmodulator steuern, während die restlichen niederwertigen Stellen mittels eines Digital-Analog-Wandlers in das erwähnte pulsamplitudenmodulierte Signal überführt werden.

Die Erfindung wird nun anhand der Figuren der Zeichnung näher erläutert.

Fig. 1 zeigt das Prinzipschaltbild eines bevorzugten Ausführungsbeispiels der Erfindung.

Fig. 2 zeigt verschiedene Kurvenformen, wie sie bei der Anordnung nach Fig. 1 auftreten, und

Fig. 3 zeigt in gegenüber Fig. 2 komprimiertem Zeitmaßstab einige der Kurven aus Fig. 2.

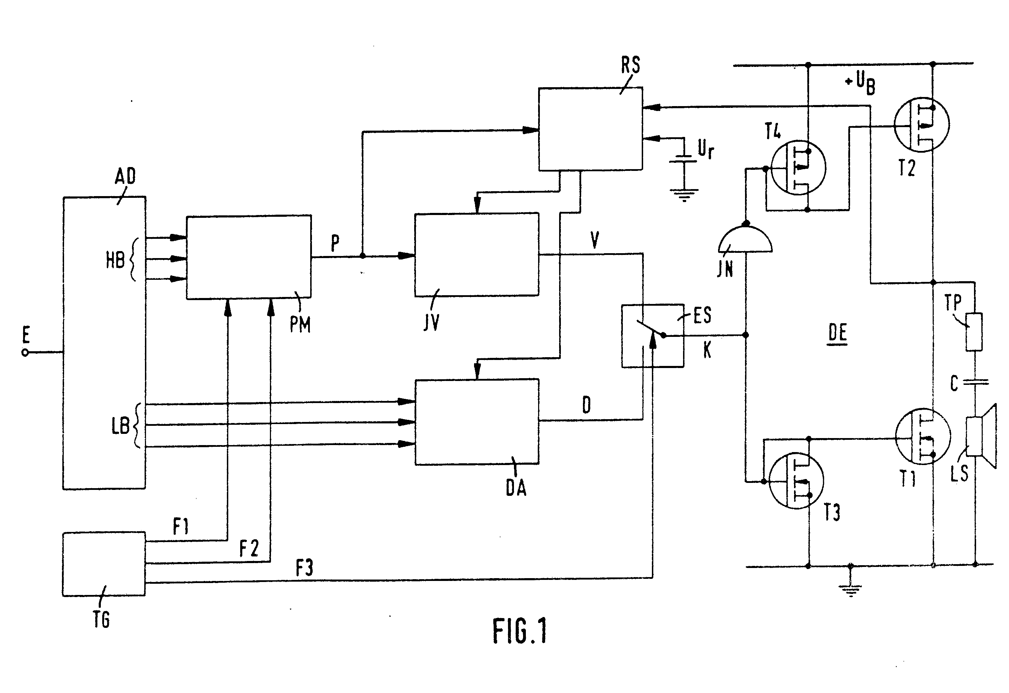

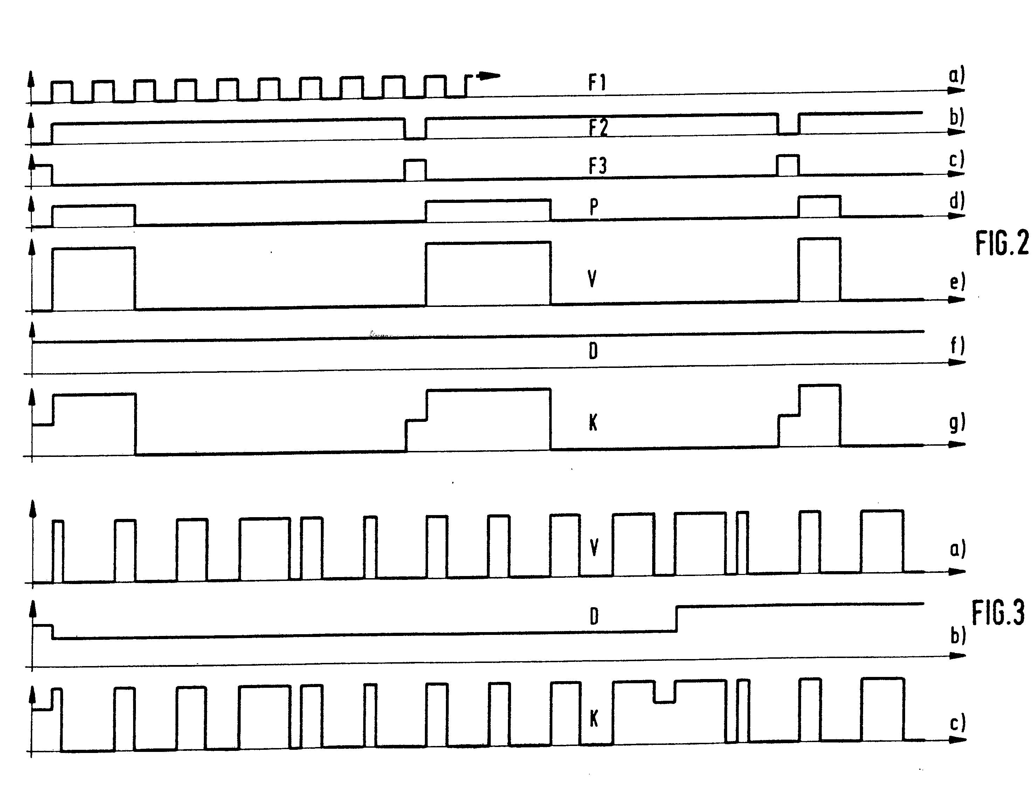

In Fig. 1 ist, zum Teil blockschaltbildmäßig, die Prinzipschaltung eines Ausführungsbeispiels der Erfindung gezeigt. Das zu verstärkende analoge Audio-Signal wird am Eingang E zugeführt. Dieser liegt am Eingang des Analog-Digital-Wandlers AD, der von bekannter Art sein kann und an seinem Ausgang ein binärcodiertes Ausgangssignal abgibt. In Fig. 1 ist der Einfachheit halber vorausgesetzt, daß dieses Ausgangssignal sechs Bit umfaßt, die hinsichtlich ihrer weiteren Verarbeitung in die (drei) höherwertigen Stellen HB und die (drei) niederwertigen Stellen LB aufgeteilt sind. Die niederwertigen Stellen LB sind dem Digital-Analog-Wandler DA zugeführt, der daraus an seinem Ausgang ein pulsamplitudenmoduliertes Signal erzeugt, vgl. die Kurve D in Fig. 2f und Fig. 3b. Die Referenzspannung des Digital-Analog-Wandlers wird ihm von der getasteten Regelstufe RS zugeführt.

Die restlichen höherwertigen Stellen HB des Ausgangssignals des Analog-Digital-Wandlers AD sind dem Eingang des Pulsbreitenmodulators PM zugeführt. Dieser kann beispielsweise aus einem Rückwärtszähler bestehen, der von den höherwertigen Stellen HB gesetzt wird und der die Taktimpulse F1 des Taktgenerators TG zählt, solange das Taktsignal F2 des Taktgenerators TG bei positiver Logik den H-Pegel hat. Die beiden Taktsignale F1, F2 sind in den Fig. 2a und b gezeigt. Ferner zeigt Fig. 2d beispielhaft einige Ausgangsimpulse P des Pulsbreitenmodulators PM, wovon der links in Fig. 2d gezeigte Impuls zwei Periodendauern des Taktsignals F1 breit ist, der in der Mitte gezeigte Impuls drei Periodendauern und der rechts gezeigte Impuls eine Periodendauer breit ist.

Der H-Pegel des Taktsignals F2 wird jeweils während soviel Taktperioden des Taktsignals F1 erzeugt, wie der maximalen Impulsbreite des Pulsbreitenmodulators PM entspricht, welche Breite von der Anzahl der höherwertigen Stellen HB abhängt, die dem Eingang des Pulsbreitenmodulators PM zugeführt sind. Bei dem gewählten Beispiel mit drei höherwertigen Stellen HB ist der H-Pegel des Taktsignals F2 also immer acht Taktperioden des Taktsignals F1 lang. Ihm folgt ein eine halbe solche Taktperiode langer L-Pegel.

Das Ausgangssignal des Pulsbreitenmodulators PM ist dem Eingang des Impulsverstärkers IV sowie dem Tasteingang der getasteten Regelstufe RS zugeführt. Die Verstärkung des Impulsverstärkers IV ist von einem aus der getasteten Regelstufe RS stammenden Steuersignal so eingestellt, daß die Amplitude seines Ausgangssignals V gleich der höchsten auftretenden Amplitude des Ausgangssignals D des Digital-Analog-Wandlers DA ist.

Das Ausgangssignal V des Impulsverstärkers IV und das Ausgangssignals D des Digital-Analog-Wandlers DA sind mittels des elektronischen Umschalters ES, der vom Taktsignal F3 des Taktgenerators TG gesteuert ist, miteinander derart kombiniert, daß zwischen jeweils zweien der Ausgangsimpulse des Impulsverstärkers IV das Ausgangssignal D des Digital-Analog-Wandlers DA erscheint. Das dadurch entstehende Kombinationssignal K ist in Fig. 2g und in Fig. 3c gezeigt. Das Taktsignal F3 geht in einfacher Weise durch Inversion aus dem Taktsignal F2 hervor. Während des eine halbe Periodendauer des Taktsignals F1 breiten Impulses des Taktsignals F3 wird also der sonst den Ausgang des Impulsverstärkers IV mit dem Ausgang des elektronischen Umschalters ES verbindende Kontakt mit dem Ausgang des Digital-Analog-Wandlers DA verbunden.

Das Kombinationssignal K liegt nun einmal direkt und einmal über den Inverter IN invertiert an den beiden Steuereingängen der in Serie geschalteten D-Gegentakt-Endstufen-Hälften. Die direkt angesteuerte Hälfte besteht aus den n-Kanal-VMOS-Transistoren T1, T3, und die andere Hälfte aus den p-Kanal-VMOS-Transistoren T2, T4. VMOS-Transistoren sind im Gegensatz zu üblichen MOS-Transistoren, solche, die einen vertikalen Aufbau der einzelnen Halbleiterschichten haben und die im allgemeinen auch durch eine V-förmige Vertiefung an der einen Oberflächenseite des Halbleiterkörpers gekennzeichnet sind. Die wirksame Kanallänge ist bei VMOS-Transistoren nicht durch eine an der Oberfläche des Halbleiterkörpers liegende, im wesentlichen von der Form der Gate-Elektrode bestimmte Halbleiterzone gegeben, sondern durch die Diffusionstiefe der Source-Zone und durch eine in der Tiefe des Halbleiterkörpers liegende Zone.

Anstatt VMOS-Transistoren können auch DMOS-Transistoren verwendet werden, wobei das »D« für doppelt diffundiert steht.

Die VMOS- oder DMOS-Transistoren sind über die Transistoren T3, T4 in Konstantstromschaltung betrieben, was dadurch erreicht ist, daß Gate und Drain direkt miteinander verbunden sind. Ferner ist mittels der getasteten Regelstufe RS dafür Sorge getragen, daß die Transistoren T1, T2 unbedingt außerhalb ihres Sättigungsbereichs betrieben werden. Die getastete Regelstufe RS vergleicht somit die Spannungsreferenz $U_r$ mit der am Verbindungspunkt der Drain-Elektroden der Transistoren T1, T2 vorhandenen Spannung und regelt über die Referenzspannung des Digital-Analog-Wandlers DA und die Verstärkung des Impulsverstärkers IV steuernde Spannung die Amplitude des Kombinationssignals K so, daß diese immer so niedrig bleibt, daß die Aussteuerung die Transistoren T1, T2 nicht in Sättigung gelangen läßt.

Am erwähnten Verbindungspunkt der Drain-Elektroden der Transistoren T1, T2 liegt über den Tiefpaß TP und den Entkopplungskondensator C der Lautsprecher LS.

Während in Fig. 2 der Zeitmaßstab so gewählt ist, daß die einzelnen Taktimpulse des Taktsignales F1 und die daraus abgeleiteten weiteren Impulse anschaulich gemacht werden können, ist in Fig. 3 der Zeitmaßstab gegenüber Fig. 2 so stark komprimiert, daß auch eine Änderung des Ausgangssignals D des Digital-Analog-Wandlers DA und dessen Auswirkung sichtbar gemacht werden kann, was in Fig. 2 nicht möglich ist. Dort ist über den gesamten gezeigten Zeitbereich das Ausgangssignal D konstant. In Fig. 2g und Fig. 3c, die beide das Kombinationssignal K am Ausgang des elektronischen Umschalters ES nach Fig. 1 zeigen, ist jeweils zwischen zweien der Ausgangsimpulse des Impulsverstärkers IF (Fig. 2e, Fig. 3a) ein Impuls mit der Amplitude des Ausgangssignals D des Digital-Analog-Wandlers DA zu sehen.

Durch die Erfindung wird somit erreicht, daß die Frequenz des Taktsignals F1 wesentlich niedriger liegen kann. Der Faktor dieser Verringerung liegt, wenn das Ausgangssignal des Analog-Digital-Wandlers AD so aufgeteilt wird, daß die Anzahl der niederwertigen Stellen LB gleich der der höherwertigen Stellen HB ist bei $2^{S/2}$, wobei mit S die Anzahl der Stellen des Ausgangssignals des Analog-Digital-Wandlers AD bezeichnet ist. Bezogen auf das in der Einleitung erwähnte Beispiel mit einer Auflösung von 10 Bit, die zu einer Taktfrequenz von etwa 500 MHz führt, ergibt sich somit eine Reduzierung um den Faktor 32 auf etwa 17 MHz.

Der Audio-Leistungsverstärker nach der Erfindung läßt sich ohne weiteres in Form monolithisch integrierter Schaltungen realisieren, wobei lediglich die D-Gegentakt-Endstufe ggf. mittels separater Transistoren realisiert werden muß. Für diese Realisierung bietet sich somit, da der Verstärker im wesentlichen nach digitalen Prinzipien arbeitet, die bekannte MOS-Technik besonders an.

**Patentanspruch**

Audio-Leistungsverstärker mit einem Pulsbreitenmodulator (PM) und einer D-Gegentakt-Endstufe (T1, T3; T2, T4), wobei die in Serie liegenden D-Gegentakt-Endstufen-Hälften, die jeweils aus einem außerhalb der Sättigung betriebenen VMOS- oder DMOS-Transistor (T1, T2) bestehen, von einem Audiosignal und dem dazu inversem Signal angesteuert sind, gekennzeichnet durch folgende Merkmale

— die Eingangsstufe ist ein Analog-Digital-Wandler (AD), der ein binärcodiertes Ausgangssignal abgibt,
— die niederwertigen Stellen (LB) des Ausgangssignals des Analog-Digital-Wandlers (AD) sind dem Eingang eines Digital-Analog-Wandler (DA) und die restlichen höherwertigen Stellen (HB) dem Eingang eines Pulsbreitenmodulators (PM) zugeführt,
— das Ausgangssignal (P) des Pulsbreitenmodulators (PM) ist einem Impulsverstärker (IV) zugeführt, dessen Verstärkung von einem aus einer getasteten Regelstufe (RS) stammenden Steuersignal so eingestellt ist, daß die Amplitude seines Ausgangssignals (V) gleich der höchsten auftretenden Amplitude des Ausgangssignals (D) des Digital-Analog-Wandlers (DA) ist,

— über einen elektronischen Umschalter (ES) ist das Ausgangssignal (D) des Digital-Analog-Wandlers (DA) dem (V) des Impulsverstärkers (IV) zwischen jeweils zweien seiner Ausgangsimpulse hinzuaddiert,

— dieses Kombinationssignal (K) und das dazu inverse Signal steuern jeweils den in Konstantstromschaltung betriebenen Transistor (T1, T2) jeder D-Gegentakt-Endstufen-Hälfte, und

— das Steuersignal für die Verstärkung des Impulsverstärkers (IV) und die Referenzspannung des Digital-Analog-Wandlers (DA) sind von der vom Ausgangssignal des Pulsbreitenmodulators (PM) getasteten Regelstufe (RS) erzeugt, die die Drain-Source-Spannung der in Serie liegenden VMOS- oder DMOS-Transistoren (T1, T2) mit einer Spannungsreferenz ($U_r$) so vergleicht, daß sie außerhalb ihres Sättigungsbereichs betrieben sind.

## Claim

Audio power amplifier with a class-D push-pull output stage consisting of two series-connected VMOS or DMOS transistors (T1, T2) and with a pulse-width modulator (PM), characterized by the following features:

— the input stage is an analog-to-digital converter (AD) which provides a binary-coded output signal;

— the low-order bits (LB) of the output signal of the analog-to-digital converter (AD) are applied to the input of a digital-to-analog converter (DA), and the other, high-order digits (HB) are applied to the input of the pulse-width modulator (PM);

— the output signal (P) of the pulse-width modulator (PM) is applied to a pulse amplifier (IV) whose gain is adjusted by a control signal from a gated control stage (RS) in such a way that the amplitude of the output signal (V) of the pulse amplifier (IV) is equal to maximum amplitude of the output signal (D) of the digital-to-analog converter (DA);

— via an electronic changeover switch (ES), the output signal (D) of the digital-to-analog converter (DA) is added to the output signal (V) of the pulse amplifier (IV) between every two of the output pulses of the pulse amplifier (IV);

— this combination signal (K) and the signal inverse thereto each control one of the two VMOS or DMOS transistor (T1, T2), which are operated outside the saturation region in a constant-current configuration, and

— the control signal for the gain of the pulse amplifier (IV) and the reference voltage of the digital-to-analog converter (DA) are generated by the control stage (RS), which is gated by the output signal of the pulse-width modulator (PM) and compares the drain-source voltages of the series-connected VMOS or DMOS transistors (T1, T2) with a voltage reference ($U_r$) so that these transistors are operated outside their saturation region.

## Revendication

Amplificateur de puissance pour audiofréquences comprenant un modulateur de largeurs d'impulsions (PM) et un étage final en push-pull classe D (T1, T3; T2, T4) dans lequel les moitiés de l'étage final en push-pull montées en série, sont constituées par des transistors VMOS ou DMOS (T1, T2) employés en dehors de leur régime de saturation et sont commandées par un signal à audiofréquences et par un même signal inversé, caractérisé en ce que:

— l'étage d'entrée est un convertisseur analogique-numérique (AD) qui fournit un signal de sortie à codage binaire;

— les chiffres de rangs faibles (LB) du signal de sortie du convertisseur analogique-numérique (DA) sont appliqués à l'entrée d'un convertisseur numérique-analogique (DA) et les chiffres des autres rangs plus élevés (HB) sont appliqués à l'entrée d'un modulateur de largeur d'impulsions (PM);

— le signal de sortie (P) du modulateur de largeur d'impulsions (PM) est amené à un amplificateur d'impulsions (IV) dont le gain est réglé par un signal de commande provenant d'un étage de réglage commuté (RS) de telle sorte que l'amplitude de son signal de sortie (V) soit égale à l'amplitude la plus élevée du signal de sortie (D) du convertisseur numérique-analogique (DA);

— le signal de sortie (D) du convertisseur numérique-analogique (DA) est ajouté à celui (V) de l'amplificateur d'impulsions (IV) entre ses impulsions de sortie, par l'intermédiaire d'un commutateur électronique (ES);

— ce signal combiné K et un signal inverse commandent respectivement les transistors (T1, T2), monté dans un circuit à courant constant, de chaque moitié de l'étage final en push-pull classe D;

— le signal de commande de gain de l'amplificateur d'impulsions (IV) et la tension de référence du convertisseur numérique-analogique (DA) sont engendrés par l'étage de réglage (RS) commuté par le signal de sortie du modulateur de largeur d'impulsions (PM), qui compare la tension drain-source des transistors VMOS ou DMOS (T1; T2) monté en série à une tension de référence $U_r$, de manière à ce que ceux-ci soient employés en dehors de leur régime de saturation.

FIG.1

FIG.2

FIG.3

0 039 430